Europäisches Patentamt

(19) European Patent Office

Office européen des brevets

(11) Publication number: **0 034 508**
A1

## (12) EUROPEAN PATENT APPLICATION

(21) Application number: **81300744.0**

(22) Date of filing: **23.02.81**

(51) Int. Cl.³: **H 01 L 21/31**
**H 01 L 27/06, G 11 C 11/34**

(30) Priority: **22.02.80 US 123848**

(43) Date of publication of application:
**26.08.81 Bulletin 81/34**

(84) Designated Contracting States:
**DE FR NL**

(71) Applicant: MOSTEK CORPORATION
1215 West Crosby Road
Carrollton Dallas, Texas 75006(US)

(72) Inventor: Chan, Tsiu C.
1633 Camero Drive
Carrollton Texas 75006(US)

(74) Representative: Smith, Philip Antony et al,
REDDIE & GROSE 16 Theobalds Road
London WC1X 8PL(GB)

(54) Self-aligned buried contact and method of making.

(57) An active region is surrounded by channel stop regions (18) covered with thick oxide (20). Initially the active region is masked by a nitride layer over a thermally-grown oxide layer. Windows (22) are formed in the mask by conventional methods to separate a channel region under portion 24 of the masking layer from contact regions under portion 26. The substrate (10) of one conductivity type is doped through the windows (22) with material of a second conductivity type. Thick oxide portions are now formed over the doped regions and the masking layers are thereafter removed. A thin oxide layer is grown over the channel region. Conductors, preferably of poly-crystalline silicon are formed over the channel and contact regions. The contact region of the substrate is then doped with a material of the second conductivity type, preferably through the polycrystalline silicon layer.

FIG. 3

FIG. 5

EP 0 034 508 A1

1

# SELF-ALIGNED BURIED CONTACT AND METHOD OF MAKING

The present invention relates to buried contact structures in MOS devices and more particularly to a self-aligned buried contact.

The MOS semiconductor device art is well developed and many techniques are know for construction of various types of MOS devices. The basic MOS device is the transistor having a channel defined primarily by a thin oxide region on a substrate and a metal gate overlying the thin oxide region. Diffused regions having a conductivity opposite to that of the substrate are provided at each end of the channel to provide drain and source regions of the semiconductor device. For the device to be operative, electrical contact must be made to all three terminals, that is source, gate and drain.

U.S. Patent 3,752,711 issued to Koo on August 14, 1973, teaches a number of methods for construction of a simple MOS transistor structure. The final step of the method taught in that patent leaves the source and drain regions covered with a fairly thick oxide layer. Conventional contact methods require the use of photomask techniques to etch openings in the oxide covering the drain and source diffusion so that a metal layer may then be patterned on the substrate to contact these regions. Thus it is quite apparent that the positions of the actual contacts to the drain and source regions, relative to the channel, are affected by the degree of accuracy in mask fabrication and alignment. As a result, it is generally necessary to make the drain and source regions, contact openings and contact to gate electrode spacings larger than would otherwise be required to allow for misalignment and other errors.

## SUMMARY OF THE INVENTION

An object of the present invention is to provide a self-aligned buried contact structure.

Another object of the present invention is to provide a method for manufacture of MOS semiconductor devices having buried contacts which are self-aligned with other portions of the device such as the active channel.

In accordance with the present invention a contact region is defined by a nitride layer deposited on a semiconductor substrate which layer also defines the active channel region. The nitride pattern is used for doping and growing thick oxide over a region between the contact and channel regions so that after removal of the nitride the thick oxide defines the contact region. A self-aligned contact therefore comprises a region of a substrate of a first conductivity type bordered by thick oxide covered doped regions and a conductor deposited over the contact region.

## BRIEF DESCRIPTION OF THE DRAWINGS

The present invention may be better understood by reading the following detailed description of the preferred embodiments with reference to the accompanying drawings wherein:

Figures 1 through 5 are cross-sectional ilustrations of a semiconductor substrate illustrating various stages in the construction of a simple MOS transistor;

Figure 6 is a plan view of a portion of a semiconductor substrate on which a random access memory has been partially fabricated; and

Figure 7 is a cross-section along the line 7-7 of Figure 6 illustrating the structure of the random access memory at a later stage in the manufacturing process.

## DESCRIPTION OF THE PREFERRED EMBODIMENTS

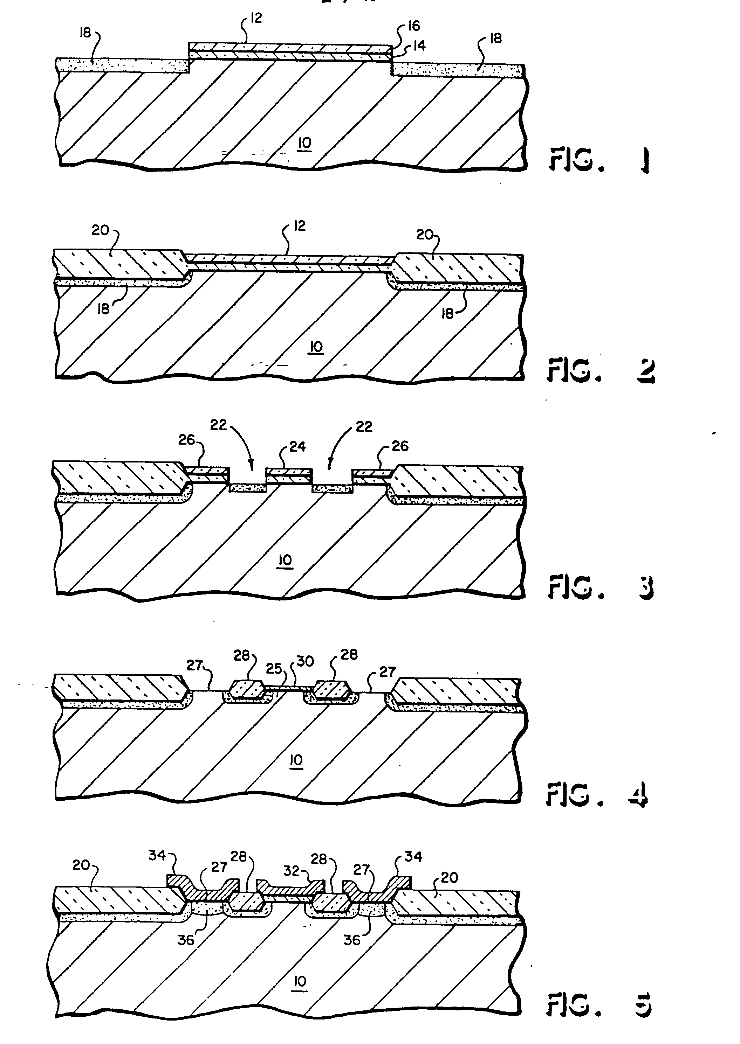

With reference now to Figures 1 through 5, the method of manufacturing an MOS transistor according to the present invention is illustrated. With particular reference to Figure 1, there is illustrated a p-type substrate 10 having a masking layer 12 for preventing oxidation and diffusion in the masked area. Layer 12 preferably includes a layer 14 of thermally grown oxide on the surface of substrate 10 and an overlying layer 16 of silicon nitride. The unmasked portions of the surface substrate 10 are doped with a p-type impurity to provide p+ channel stop zones 18 in a known manner.

The doping of zones 18 may be either by ion implantation techniques or diffusion techniques.

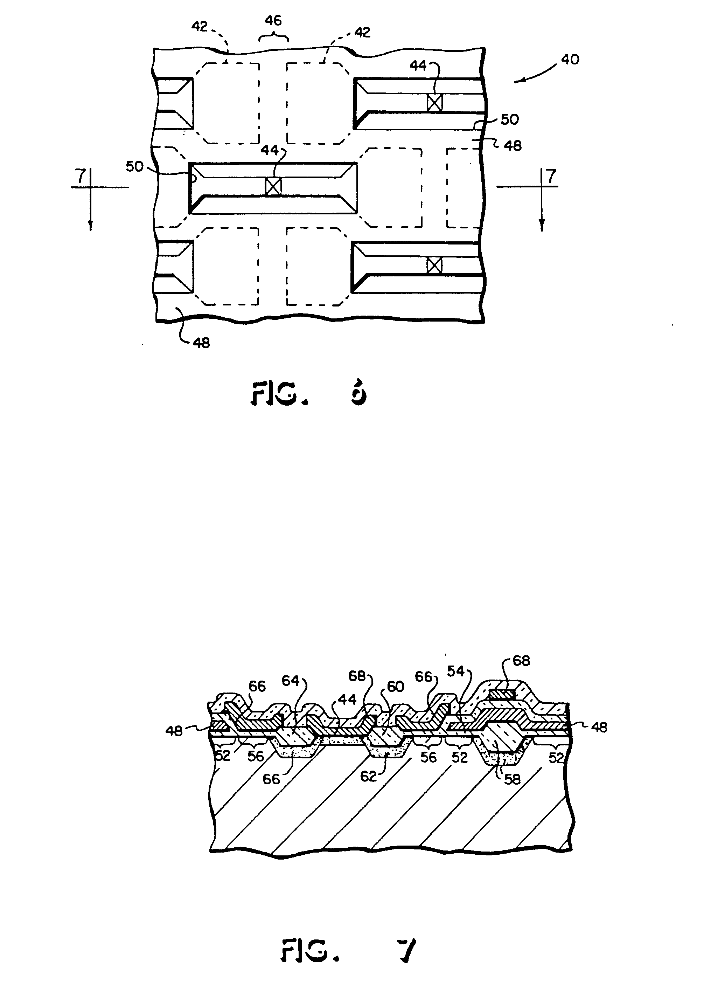

In Figure 2, the substrate 10 has been subjected to an oxidation treatment to grow thick or field oxide layers 20 over the channel stop diffusions 18. After this step, the active region defined by the masking layer 12 is completely surrounded by the thick oxide 20 and channel stop regions 18.

As illustrated in Figure 3, the next step of the process involves using conventional photomask and etching techniques to open two windows 22 in the masking layer 12. The remaining portions 24 and 26 of the masking layer 12 define a channel region, under portion 24, and two contact regions under portions 26. The windows 22 expose regions between the channel and contact regions. An n-type impurity is then diffused or implanted into the surface of substrate 10 through the windows 22. Preferably, arsenic is used to provide an n+ doping in a low energy ion implant process. While ion implantation could normally be performed through the thin oxide region 14, the oxide 14 is removed in the window areas 22 since a low energy ion process is preferred.

The next step of the process, as illustrated in Figure 4, is to subject the substrate 10 to another oxidation step to generate thick oxide portions 28 over the regions defined by windows 22 in Figure 3. The n+ doped regions are driven further into substrate 10 during the oxidation process to provide conductive regions between the channel region 25 and contact regions 27. Although not illustrated in Figure 4, the nitride layer 16 remains intact during the generation of the oxide layer 28 to prevent oxidation of the channel and contact regions. After formation of the oxide regions 28, the nitride layer 16 is entirely removed and the oxide layer 14 is removed at least from the contact areas 27. In a preferred form, the oxide layer 14 is also removed from the channel region 25 and a new thin oxide layer 30 is formed over the channel 25.

In this preferred form, new thin oxide layers are also formed on contact regions 27, but these are removed using conventional photomask and etching techniques.

The final steps of the process are illustrated in Figure 5. In a preferred form, a polysilicon layer is formed over the entire substrate 10 as illustrated in Figure 4 and then etched to provide a gate 32 and source and drain contacts 34. The substrate 10 is then subjected to a doping process in which n+ doped areas 36 are formed within the contact areas 27 below the source and drain contacts 34. This doping process is performed directly through the source and drain polycrystalline silicon contacts 34. Either a normal diffusion process or an ion implantation process may be employed for this step. The contacts 34 and gate 32 may be formed from a normal interconnect metal, such as aluminum, if the doped regions 36 are formed before deposition of the contacts 34.

It can be seen from the above described process that the actual contact areas 27 are totally defined when the masking layer 12 is etched to generate the channel and contact portions 24 and 26. While the masking layer 26 must be removed to allow deposition of the metal contacts 34 on the surface and formation of the doped regions 36, it is clear that the masks for removing the portion 26 may be considerably larger than the actual contact areas 27 and may be somewhat misaligned. The actual locations of the contact areas 27 are bordered by the thick oxide layers 20 and 28. As a result, the locations of the contacts 27 relative to the channel region 30 are determined in a single photomasking step and are independent of misalignment of later masks.

While the present invention has been described in terms of fabrication of a single MOS transistor in Figures 1 through 5, it is apparent that the selfaligned buried contact may be quite useful in reducing total circuit area in complicated MOS integrated circuit devices. Figures 6 and 7 illustrate portions of a MOS random access memory integrated circuit device incorporating the present invention. The basic structure of this random access memory may be better understood by reference to U.S. Patent 4,012,757 issued to Koo on March 15, 1977 which is hereby incorporated by reference. Figure 6 in particular shows a section of a MOS integrated circuit 40 which corresponds generally to Figure 3 of the Koo patent. This section 40 includes a number of capacitive storage cells 42 defined by the finger like projections. The cells 42 correspond to the cells 32a and 32b of the Koo patent. However, the column select lines numbered 30a and 30b in that patent have been omitted from section 40. Instead, each pair of the projections 42 meet in contact areas 44. According to the present invention, the diffused column select lines of Koo are replaced with a surface layer of polycrystalline silicon. As a result, the space 46 between adjacent capacitive sections of the projections 42 need only be large enough to provide a channel stop structure comprising a p+ doped region and a field oxide surface layer such as elements 18 and 20 of Figures 1 through 5. A polycrystalline upper capacitor plate 48 is also illustrated in Figure 6 covering substantially the entire section 40 except for windows 50, allowing access to the contacts 44 and to the active channel regions of the projections 42. The polycrystalline gates and polycrystalline column select lines are not illustrated in Figure 6 since they would tend to obscure the underlying structure. It will be seen that these two polycrystalline structures can be formed in the same polycrystalline silicon deposition according to the present invention.

With reference now to Figure 7, there is illustrated a cross-section of the Figure 6 structure taken along the line 7-7. Electrically, this structure comprises a conventional MOS capacitive storage random access memory cell. A storage capacitor is formed between a section 52 of the surface of silicon substrate 40 and the polycrystalline layer 48. A thin oxide layer 54 isolates the layer 48 from substrate 40. A channel 56 is provided between the storage capacitor section 52 and the buried contact 44. A channel stop structure 58 is provided between adjacent capacitive portions 52. The structure 58 includes a p+ doped region and a layer of thick or field oxide formed as illustrated in Figures 1 and 2. Another thick oxide region 60 overlying an n+ doped region 62 defines the buried contact 44 and provides electrical connection between contact 44 and channel region 5. A second thick oxide region 64 and n+ doped region 66 define a second side of the buried contact 44 and provide electrical connection to an adjacent storage cell. The electrical operation of the structure is well known as taught by the above referenced Koo patent.

The structure of Figure 7 is fabricated in essentially the same manner as taught in Figures 1 through 5 modified as necessary according to the teachings of the above referenced Koo patent. Thus, in this type of random access memory, only a source contact is provided adjacent the channel region 56 since the drain is merged with the capacitive region 52 in the surface of the substrate. Therefore, in fabrication of the device, only one window, such as window 22 in Figure 3, is opened up adjacent the channel region 56 for generation of the thick oxide area 60. In fabrication of the entire memory, a large number of such windows are opened up but there is only one such window 22 for each MOS active device. Th thick oxide region 64 corresponds to an adjacent memory cell. Prior to opening of the windows 22, the channel stop region 58 is generated in a conventional manner to define the overall active regions 42. After generation of the oxide regions 60 and 64, the thin oxide region 54 is provided over the channel and capacitor regions 52 and 56 of substrate 40. A polycrystalline silicon layer is then deposited over the entire substrate and patterned in a conventional manner to open the windows 50 and thereby form the upper capacitor plates 48. An insulating oxide layer is then formed over the first polycrystalline layer 48 and a second polycrystalline silicon deposition is made. The second layer is patterned to form gates 66 for the channels 56 and column select lines 68 which also form the surface portion of the buried contacts 44. After deposition of the second polycrystalline layer, the n+ diffusions are formed in the contacts 44 as described above. More oxide is then grown over the second polycrystalline layer so that the metal word lines may be deposited on top of the structure for making contact to the appropriate gates 66. With reference to the prior structures, it can be seen that the structure of Figure 7 provides a random access memory integrated circuit having increased density and corresponding better use of silicon surface area. The savings in space is greater than the dimension of the diffused column select line used in the prior art. The use of the diffused line required additional spacing of the capacitive storage areas from that line which is not required in the present structure. The net result is approximately a 20% reduction in surface area per cell. The reduced cell dimensions allow the production of a more complicated memory on a silicon chip of a given size or the reduction in dimensions of a memory of a given complexity with resulting improvement in yield. In any case, the 20% reduction in cell size represents a significant improvement in these memory devices.

CLAIMS:

1. A method for making a self-aligned buried contact in an MOS semiconductor device comprising:

(a) depositing a silicon nitride layer on a substrate of a first conductivity,

(b) patterning said silicon nitride layer to define a channel region and a contact region spaced from said channel region by a third region,

(c) doping the surface of said substrate in said third region with a dopant of a second conductivity,

(d) growing thick oxide over said third region,

(e) removing said silicon nitride layer from said channel and contact region,

(f) forming a thin oxide layer on said channel region, and

(g) in either order,

doping said contact region with a dopant of said second conductivity, and

depositing a conductor over said contact region.

2. A method according to Claim 1 wherein in step (g); said conductor comprises polycrystalline silicon and said doping of said contact regions occurs after depositing of said conductor.

3. A method according to Claim 2 wherein said doping comprises the diffusion of a dopant in said contact region.

4. A method according to Claim 1 wherein in step (c) said doping comprises the ion implantation of a dopant.

5. A method according to Claim 1 further including:

prior to step (a) forming a thin oxide layer on said substrate wherein step (b) includes patterning of said thin oxide layer.

6. A method according to Claim 5 wherein said thin oxide layer is formed on said channel region by in step (e) removing only said silicon nitride layer from said channel region.

7. A method according to Claim 5 wherein step (e) includes removing of said thin oxide layer formed prior to step (a).

8. A self-aligned contact semiconductor structure comprising:

(a) a semiconductor substrate of a first conductivity

(b) a contact area of a second conductivity on a surface of said substrate,

(c) doped regions on each side of said contact area,

(d) thick oxide over said doped regions,

(e) conductive metallization over said contact area.

9. A structure according to Claim 8 wherein said doped areas are of a second conductivity.

10. A structure according to Claim 8 wherein a least one of said doped regions is of said first conductivity and the remaining of said doped regions are of a second conductivity.

11. A structure according to Claim 8 wherein said conductive metalization also overlaps at least a portion of said thick oxide.

12. A structure according to Claim 8 wherein said conductive metalization comprises polycrystalline silicon of a second conductivity type.

0034508

FIG. 1

FIG. 2

FIG. 3

FIG. 4

FIG. 5

FIG. 6

FIG. 7

0034508

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| | US - A - 4 187 602 (TEXAS INSTRUMENTS) <br> * claims 1, 2, column 4, line 29 to column 6, line 48; fig. 4a to 4f * <br> -- | 1-5, 7-12 | H 01 L 21/31 <br> H 01 L 27/06 <br> G 11 C 11/34 |
| | GB - A - 2 021 861 (ROCKWELL) <br> * page 4, line 95 to page 5, line 28; fig. 4, 6, 7, 9 to 11 * <br> -- | 1-4, 8-10, 12 | |
| | DE - A1 - 2 802 048 (MOSTEK) <br> * claim 1; pages 21 to 26; fig. 1 to 6 * <br> ---- | 1,4 | TECHNICAL FIELDS SEARCHED (Int. Cl.³) <br><br> G 11 C 11/21 <br> H 01 L 21/31 <br> H 01 L 27/06 |

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

X The present search report has been drawn up for all claims

| Place of search | Date of completion of the search | Examiner |
|---|---|---|
| Berlin | 21-05-1981 | ROTHER |

EPO Form 1503.1 06.78